# EUROPEAN PATENT SPECIFICATION

(11) **EP 1 403 228 B1**
(45) Date of publication and mention of the grant of the patent: **24.01.2007**
(21) Application number: 02736160.9
(22) Date of filing: 18.06.2002
(51) Int. Cl.: C04B 35/64

(54) **CERAMIC COMPONENT AND PRODUCTION METHOD THEREFOR**
KERAMISCHE KOMPONENTE UND DESSEN HERSTELLUNGSVERFAHREN
COMPOSANT CERAMIQUE ET PROCEDE DE FABRICATION ASSOCIE

(30) Priority: 25.06.2001 JP 2001190966
(43) Date of publication of application: 31.03.2004
(73) Proprietor: MATSUSHITA ELECTRIC INDUSTRIAL CO., LTD., Kadoma-shi, Osaka 571-8501 (JP)
(72) Inventor: KATSUMURA, Hidenori, Kobe-shi, Hyogo 658-0025 (JP); SAITO, Ryuichi, Hirakata-shi, Osaka 573-1136 (JP); WAKABAYASHI, Tsukasa, Neyagawa-shi, Osaka 573-0036 (JP); KAGATA, Hiroshi, Hirakata-shi, Osaka 573-0035 (JP)
(74) Representative: Grünecker, Kinkeldey, Stockmair & Schwanhäusser Anwaltssozietät
(86) International application number: PCT/JP2002/006077
(87) International publication number: WO 2003/000619

(56) References cited:
- JP-A- 11 185 528
- JP-A- 11 251 723
- JP-A- 2000 049 431
- JP-A- 2000 285 731
- JP-A- 2001 158 670
- US-A- 4 493 789
- US-A- 5 468 445
- US-A- 6 146 743

## Description

### TECHNICAL FIELD

The present invention relates to a ceramic component represented by a ceramic multilayered substrate on which semiconductor ICs, chips, and the like are mounted and wired to one another. It also relates to a method of manufacturing the ceramic component.

### BACKGROUND ART

With recent advances in downsizing and weight reduction of semiconductor ICs, chips, and the like, downsizing and weight reduction of wiring boards on which such components are mounted are also desired. Ceramic multilayered substrates are valued in today's electronics industry, because they allow required higher-density wiring thereon and can be formed as thinner layers.

A general method of manufacturing a ceramic multilayered substrate includes the steps of:
(1) preparing and mixing ceramic materials;
(2) forming a ceramic green sheet;
(3) producing conductor paste; and
(4) firing a composite laminate that comprises green sheet layers and conductor layers.

In the firing step, the ceramic multilayered substrate is shrunken by sintering. The shrinkage caused by sintering varies with the substrate materials used, composition of the green sheet, lots of the fine particle, and other factors. The shrinkage poses several problems in production of the multilayered substrate.

One of the major problems is a shrinkage error. In the process of manufacturing a ceramic multilayered substrate, after electrodes on the inner layer is fired, wiring on the uppermost layer is formed. Therefore, when the shrinkage error in the substrate materials is large, the difference in dimension between the electrodes on the inner layer and the wiring pattern on the uppermost layer makes it impossible to connect electrodes on the inner layer to the wiring pattern on the uppermost layer. In order to address this problem, land patterns of an unnecessarily large area must be formed for electrodes on the uppermost layer so that the land patterns accommodate to the shrinkage error. For this reason, such a ceramic multilayered substrate is inappropriate for a circuit requiring high-density wiring.

One of the countermeasures is preparing a number of screens for the wiring on the uppermost layer according to the shrinkage error and using one of the screens according to the percentage of shrinkage of the substrate. This method requires a large number of screens and thus is uneconomical. On the other hand, for a co-firing method for forming of the wiring on the uppermost layer and firing the electrodes on the inner layer at the same time, large land patterns are unnecessary. However, another problem remains. Because the shrinkage error in the substrate itself still exists, in some cases, cream solder cannot be applied to required portions of the ceramic multilayered substrate, in the cream solder printing process for finally mounting components on the substrate.

Disclosed in the Japanese Patent No. 2785544 is a method of: laminating a desired number of green sheets that comprise glass ceramic mixed fine particles to sinter at low temperatures and have electrode patterns formed thereon; laminating, on at least one side of the laminate, a heat-shrinkage inhibiting green sheet made of inorganic composition that does not sinter at the firing temperature of the glass ceramic mixed fine particles (hereinafter referred to as a "heat-shrinkage inhibiting sheet"); firing the laminate; and removing the heat-shrinkage inhibiting layer. As an advantage of the invention, the substrate materials tend to be fired along the direction of the thickness thereof, and thus a substrate in which plane-directional shrinkage is inhibited can be produced. Therefore, the above-mentioned problem can be solved. Although a substrate in which plane-directional shrinkage is unlikely to occur can be obtained by the method described in the publication, a problem still remains. Because the substrate tends to shrink along the direction of thickness thereof, defects such as cracks occur around inner electrodes in the substrate after firing.

The major cause of this problem is considered that there is a large difference in the sintering timing or heat-shrinkage behaviors between the conductor paste and the green sheet laminate in the firing process. A large difference in the shrinkage behaviors in sintering between the green sheet laminate and the conductor paste produces excessive stress or distortion between the fired substrate and electrodes, thereby producing the above-mentioned defects such as cracks.

For the ordinary firing method, because the shrinkage occurs in three-dimensional directions in the firing process, produced cracks can recover during the firing process, if they are small. On the other hand, for the manufacturing method described in the publication, because no shrinkage occurs in the plane direction in the firing process, defects such as cracks are unlikely to recover once produced. When these defects such as cracks occur in the substrate, reliability of the substrate deteriorates, which poses a problem.

### DISCLOSURE OF INVENTION

The present invention aims to address the problems of the conventional manufacturing methods described above. Therefore, it is an object of the present invention to provide a ceramic component with high reliability and accuracy in dimension in which electrical characteristics thereof are not largely deteriorated and occurrence of defects such as cracks around inner electrodes thereof are inhibited, in a firing technique with high accuracy in dimension for sandwiching a glass ceramic laminate with heat-shrinkage inhibiting sheets and firing them.

In order to achieve this object, the method of manufacturing a ceramic component of the present invention includes:
a conductor printing step of applying, to a glass ceramic green sheet, conductor paste that has substantially the same sintering speed as the glass ceramic green sheet;
a lamination step of laminating a plurality of the glass ceramic green sheets to form a laminate;
a composite lamination step of further laminating, on at least one side of the laminate, a heat-shrinkage inhibiting green sheet based on inorganic material to form a composite laminate;
a debindering step of burning out organic material from the composite laminate;
a firing step of sintering the composite laminate after the removal of the organic material so that the sintering behaviors of the glass ceramic green sheets and the conductor paste match with each other; and
a step of removing the inorganic material in the heat-shrinkage inhibiting green sheet.

This method can provide a ceramic component with high reliability and accuracy in dimension.

### BRIEF DESCRIPTION OF DRAWINGS

Fig. 1 is a sectional view illustrating a firing technique of one embodiment of the invention for sandwiching a ceramic laminate with heat-shrinkage inhibiting sheets and firing them.
Fig. 2 is a sectional view illustrating a portion having a defect in the vicinity of a conductor layer.

### BEST MODE FOR CARRYNG OUT THE INVENTION

Exemplary embodiments of the present invention are demonstrated hereinafter.

First, a method of preparing a glass ceramic mixed material is described. The glass ceramic mixed material used herein is based on a mixture of alumina (Al₂O₃), magnesium oxide (MgO), and samarium oxide (Sm₂O₃) (hereinafter referred to as an "AMS mixture"), and a glass (glass fine particles containing SiO₂, B₂O₃, and CaO, softening point: 780 °C). High-purity fine particles of the raw materials were weighed in a molar ratio of Al₂O₃: MgO: Sm₂O₃ = 11:1:1. The fine particles were loaded into a ball mill, mixed for 20 hours, and then dried. The mixed particles were calcined at a temperature of 1300 °C for two hours. The calcined particles were pulverized by a ball mill for 20 hours. The pulverized powder obtained in this manner is called an AMS powder. This AMS powder and the SiO₂-B₂O₃-CaO-containing glass powder were weighed in a weight ratio of 50: 50, mixed by a ball mill for 20 hours, and then dried. A glass ceramic mixed material (hereinafter referred to as an "AMSG material") was obtained by these steps. Because the AMSG material is fired at temperatures ranging from 880 to 950 °C to become dense layer, it can be fired with silver electrodes at the same time. The dielectric constant of the AMSG material is 7.5 (1MHz).

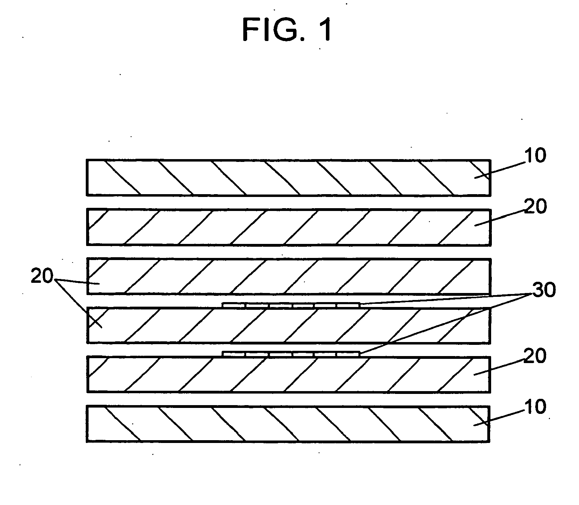

As a material of heat-shrinkage inhibiting green sheet 10 shown in Fig. 1, alumina powder (purity: 99.9 %, average particle diameter: 1.0 µm) was used.

A PVB resin as a binder, and dibutyl phthalate as a plasticizer were added to each of the above-mentioned AMSG material and the alumina powder. Then, slurry was produced using butyl acetate as a solvent. By the well-known doctor blade method, glass ceramic green sheet 20 (AMSG green sheet) and heat-shrinkage inhibiting (alumina) green sheet 10, each having a desired thickness, were produced.

Next, a method of producing conductor paste is described.

Given ratios of additives were mixed into 100 wt % of silver powder. An organic vehicle (ethyl cellulose dissolved in terpineol) was added to the paste in an amount of 20 wt % of the entire paste. The mixture was kneaded by three ceramic rollers to provide conductor paste.

This conductor paste was applied to the AMSG green sheet 20 as an electrical resistance measuring pattern (conductor layer 30), using a screen printer. Thereafter, a necessary number of AMSG green sheets 20 were laminated, and alumina green sheets 10 were further laminated on both sides to provide a structure shown in Fig. 1. Heat press bonding was performed on these materials in this state to form a laminate. The conditions for the heat press bonding were a temperature of 80 °C and a pressure of 500 kg/cm². This laminate was cut into 10 x 10 mm pieces. Each piece was placed on an alumina sagger, and heat-treated in a box oven at a temperature of 500 °C for 10 hours. After resin components were burned out by the heat-treatment, each piece was fired under the conditions where the temperature was risen to 900 °C in air at a rate of 300 °C/hr. (except for Exemplary Embodiment 3), and thereafter a temperature of 900 °C was maintained for 30 minutes.

On the surfaces of this fired laminate, alumina contained in heat-shrinkage inhibiting green sheets 10 remained without being fired. The remaining alumina was completely removed by ultrasonic cleaning in butyl acetate.

### Exemplary Embodiment 1

Discussed in the Exemplary Embodiment 1 is the effect of addition of a molybdenum oxide to the conductor paste. Table 1 shows the amount of molybdenum trioxide added to silver powder (average particle diameter: 4.0 µm) and analysis and evaluation results of each of the obtained ceramic multilayered substrates.

**Table 1**

| Sample No. | Amount of MoO₃ added (wt %) | Mode of defects | Sheet resistance (mΩ) |
|---|---|---|---|
| 1* | 0 | C | 1.9 |
| 2* | 0.05 | C | 1.9 |
| 3 | 0.1 | A | 2 |
| 4 | 1.0 | A | 2.7 |
| 5 | 2.5 | A | 3.1 |
| 6 | 5.0 | A | 3.8 |
| 7* | 6.0 | A | 6.2 |

In the table, samples marked with * show control examples of the present invention.

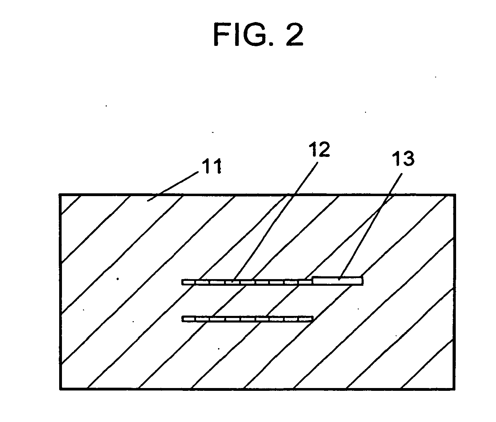

As for "Mode of defects (such as cracks)" in the evaluation items, after substrate 11 was ground, the section of the substrate was observed using an optical microscope, to classify types of defect 13, such as cracks, occurring in the vicinity of inner electrode 12 as shown in Fig. 2 into each of modes A, B, and C described below.

### Classification of modes of defect 13

"Mode A" -- no defect
"Mode B" -- a small defect with a maximum length less than 5 µm
"Mode C" -- a large defect with a maximum length of not less than 5 µm

As for "Sheet resistance", after silver electrode paste was applied to the side face of the inner conductor layer and fired to form a terminal electrode, a resistance based on an electrode area of 1 mm² and an electrode thickness of 10 µm was calculated, using a DC resistance measured with a digital multimeter and an actual measurement of the electrode thickness.

For each of the Sample No. 1 with no molybdenum trioxide added and the Sample No. 2 with a small amount of molybdenum trioxide added, a large defect occurs in the vicinity of the conductor layer (mode C). In contrast, each of the Sample Nos. 3 through 7 with at least 0.1 wt % of molybdenum trioxide added, no defect such as cracks is observed (mode A). The reason is considered that addition of molybdenum trioxide can delay sintering of the conductor layer and match the sintering behavior thereof with that of the glass ceramic laminate. Addition of less than 0.1 wt % of molybdenum trioxide cannot delay the sintering of the conductor paste sufficiently. On the other hand, the case of the Sample No. 7, for example, with excessive molybdenum trioxide added in an amount of 6.0 wt %, poses a problem that the sheet resistance of the conductor layer rapidly increases to more than 6 mΩ.

In order to effectively prevent the occurrence of defects and maintain low resistances, it is desirable to add molybdenum trioxide in amounts ranging from 0.1 to 5.0 wt %.

### Exemplary Embodiment 2

Discussed in the Exemplary Embodiment 2 is the effect of particle diameters of the silver powder that constitutes the conductor paste. As shown in Table 2, several kinds of silver powders each having an average particle diameter ranging from 2.2 to 10.2 µm were used. Several kinds of conductor pastes were produced by adding 1.0 wt % of molybdenum trioxide to 100 wt % of each conductor powder and the conductor pastes were evaluated.

**Table 2**

| Sample No. | Amount of MoO₃ added (wt %) | Particle diameter of silver powder (µm) | Mode of defects | Sheet resistance (mΩ) |
|---|---|---|---|---|
| 8 | 1.0 | 3.1 | A | 2.8 |
| 4 | 1.0 | 4.0 | A | 2.7 |
| 9 | 1.0 | 5.1 | A | 2.7 |
| 10 | 1.0 | 7.9 | A | 2.7 |
| 11 | 1.0 | 10.2 | B | 2.6 |
| 12 | 1.0 | 2.2 | B | 2.9 |

For each of the Sample Nos. 4 and 8 through 10 with a particle diameter of the silver powder ranging from 3 to 8 µm, no defect is observed in the vicinity of the conductor layer. On the other hand, each of the Sample No. 12 with a particle diameter of the silver powder so small as 2.2 µm and the Sample No. 11 with a particle diameter of the silver powder so large as 10.2 µm, a small defect occurs at the tip of the inner electrode (mode B). The reason is considered as follows. An excessively small particle diameter of the silver powder activates the surface of the silver powder and thus the temperature at which the silver powder starts to shrink in sintering is too low. For an excessively large particle diameter of the silver powder, the temperature at which the silver powder starts to shrink in sintering is too high. For these reasons, there is a large difference in the shrinkage behaviors between the conductor layer and the ceramic laminate. This large difference causes a defect in the vicinity of the electrode. There is almost no change in resistance caused by the difference in particle diameters of the silver powder.

As a result, it is desirable that the particle diameters of the silver powder constituting the conductor layer range from 3 to 8 µm.

### Exemplary Embodiment 3

Discussed in the Exemplary Embodiment 3 is the effect of rates of temperature rise in the firing process. Used was the paste of the Sample No. 4 that comprised silver powder 4.0 µm in particle diameter and contained 1.0 wt % of molybdenum trioxide added thereto.

**Table 3**

| Sample No. | Amount of MoO₃ added (wt %) | Rate of temperature rise (°C/hr) | Mode of defects | Sheet resistance (mΩ) |
|---|---|---|---|---|
| 13 | 1.0 | 100 | B | 2.9 |
| 14 | 1.0 | 200 | A | 2.7 |
| 4 | 1.0 | 400 | A | 2.7 |
| 15 | 1.0 | 900 | A | 2.7 |
| 16 | 1.0 | 1800 | A | 2.7 |
| 17 | 1.0 | 5400 | A | 2.7 |
| 18 | 1.0 | 9000 | B | 2.7 |

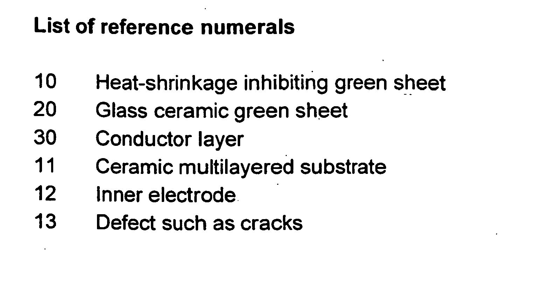

As shown in Fig. 3, for each of the Sample Nos. 4 and 14 through 17 having an average rate of temperature rise ranging from 200 to 5,500 °C/h, no defect is observed in the vicinity of the conductor layer. On the other hand, for the Sample No. 13 having an average rate of temperature rise as low as 100 °C/hr, a small defect occurs (mode B). For the Sample No. 18 having an average rate of temperature rise as high as 9,000 °C/hr, a small defect is also observed. The reason is considered as follows.

A lower rate of temperature rise makes a large time difference in the shrinkage behaviors between the conductor layer and the glass ceramic laminate and thus the defects occur. On the other hand, an excessively high rate of temperature rise causes abrupt shrinking force to be exerted on the vicinity of the conductor layer and thus the defects occur.

As a result, it is desirable that the average rates of temperature rise in the firing process range from 200 to 5,500 °C/hr.

In these embodiments, the cases where molybdenum trioxide is used are described. However, similar effects can be obtained with other types of molybdenum oxides. It is desirable that the compounding ratios of the other types of molybdenum oxides range 0.1 to 5.0 wt % on molybdenum trioxide basis.

In the embodiments of the present invention, Al₂O₃-MgO-Sm₂O₃ mixture and glass-containing material are used as a glass ceramic material. However, it has been confirmed that substantially the same effects can be obtained with an oxide of a specific lanthanoid, i.e. LnxOy, instead of Sm₂O₃ (where Ln is at least one selected from La, Ce, Nd, Sm, Eu, Gd, and Tb, and each of x and y is a value stoichiometrically determined according to the electronic number of the Ln), because the lanthanoid oxide has the same sintering behavior as Sm₂O₃.

The manufacturing method of the present invention can be used for a glass ceramic other than the above-mentioned glass ceramic comprising Al₂O₃-MgO-LnOx mixture and glass-containing material.

### INDUSTRIAL APPLICABILITY

The ceramic component manufacturing method of the present invention can provide a ceramic component with high reliability and accuracy in dimension in which electrical characteristics thereof are not largely deteriorated and occurrence of defects such as cracks around the inner electrodes in the substrate after firing are inhibited, in a firing technique with high accuracy in dimension for sandwiching a glass ceramic laminate with heat-shrinkage inhibiting sheets and firing them.

## Claims

1. A method of manufacturing a ceramic component including:
a conductor printing step of applying, to a glass ceramic green sheet, conductor paste having substantially a same sintering speed as the glass ceramic green sheet;
a lamination step of laminating a plurality of the glass ceramic green sheets to form a laminate;
a composite lamination step of further laminating, on at least one side of the laminate, a heat-shrinkage inhibiting green sheet based on inorganic material to form a composite laminate;
a debindering step of burning out organic material from the composite laminate;
a firing step of sintering the composite laminate after the removal of the organic material so that sintering behaviors of the glass ceramic green sheets and the conductor paste match with each other; and
a step of removing the inorganic material in the heat-shrinkage inhibiting green sheet.

2. The method of manufacturing a ceramic component of Claim 1, wherein, in said firing step, the composite laminate is sintered while a molybdenum oxide mixed in the conductor paste controls a sintering speed of the conductor paste so that the sintering speed thereof matches with a sintering speed of the glass ceramic.

3. The method of manufacturing a ceramic component of Claim 1, wherein the conductor paste used in said conductor printing step includes silver powder and a molybdenum oxide, and a compounding ratio of the molybdenum oxide is 0.1 to 5 wt % (on molybdenum trioxide basis) of entire powder of the conductor.

4. The method of manufacturing a ceramic component of Claim 1, wherein, in said firing step, silver powder having an average particle diameter ranging from 3 to 8 µm is selected as a silver powder used for the conductor paste, and thereby the composite laminate is sintered so that the silver powder controls a shrinkage starting temperature of the conductor paste and shrinkage behaviors of the conductor paste and the glass ceramic matches with each other.

5. The method of manufacturing a ceramic component of Claim 1, wherein the conductor paste used in said conductor printing step includes silver powder and a molybdenum oxide, and an average particle diameter of the silver powder ranges from 3 to 8 µm.

6. The method of manufacturing a ceramic component of Claim 1, wherein said firing step includes a temperature rising sub-step and a high-temperature maintaining sub-step, and a rate of temperature rise in the temperature rising sub-step ranges from 200 to 5,500 °C/hr.

7. The method of manufacturing a ceramic component of any one of Claims 1 through 6, wherein the glass ceramic green sheet including aluminum oxide, magnesium oxide, an oxide of a specific lanthanoid and glass is used.

8. A laminated glass ceramic component having a predetermined pattern of conductor layer, wherein the glass ceramic includes aluminum oxide, magnesium oxide, an oxide of a specific lanthanoid, and glass, and the conductor has silver as a major constituent thereof and includes a molybdenum oxide in an amount of 0.1 to 5 wt % of entire powder of the conductor.

## Patentansprüche

1. Verfahren zum Herstellen eines keramischen Bauteils, das umfasst:
einen Leiterdruckschritt des Auftragens von Leiterpaste auf eine Glaskeramik-Rohfolie, wobei die Leiterpaste im Wesentlichen die gleiche Sintergeschwindigkeit hat wie die Glaskeramik-Rohfolie;
einen Laminierschritt des Laminierens einer Vielzahl der Glaskeramik-Rohfolien, um ein Laminat auszubilden;
einen Verbundlaminierschritt des weiteren Laminierens wenigstens einer Wärmeschrumpfunterdrückungs-Rohfolie auf Basis eines anorganischen Materials auf wenigstens eine Seite des Laminats, um ein Verbundlaminat auszubilden;
einen Bindemittel-Entfernungsschritt des Ausbrennens von organischem Material aus dem Verbundlaminat;
einen Brennschritt des Sinterns des Verbundlaminats nach dem Entfernen des organischen Materials, so dass das Sinterverhalten der Glaskeramik-Rohfolien und das der Leiterpaste einander entsprechen; und
einen Schritt des Entfernens des anorganischen Materials in der Wärmeschrumpfunterdrückungs-Rohfolie.

2. Verfahren zum Herstellen eines keramischen Bauteils nach Anspruch 1, wobei in dem Brennschritt das Verbundlaminat gesintert wird und dabei ein Molybdänoxid, das der Leiterpaste beigemischt ist, eine Sintergeschwindigkeit der Leiterpaste so steuert, dass die Sintergeschwindigkeit derselben einer Sintergeschwindigkeit der Glaskeramik entspricht.

3. Verfahren zum Herstellen eines keramischen Bauteils nach Anspruch 1, wobei die Leiterpaste, die bei dem Leiterdruckschritt verwendet wird, Silberpulver und ein Molybdänoxid enthält und ein Mischungsanteil des Molybdänoxids 0,1 bis 5 Gew.-% (auf Basis von Molybdäntrioxid) des gesamten Pulvers des Leiters beträgt.

4. Verfahren zum Herstellen eines keramischen Bauteils nach Anspruch 1, wobei in dem Brennschritt Silberpulver mit einem durchschnittlichen Teilchendurchmesser zwischen 3 und 8 µm als ein Silberpulver ausgewählt wird, das für die Leiterpaste verwendet wird und so das Verbundlaminat so gesintert wird, dass das Silberpulver eine Schrumpf-Anfangstemperatur der Leiterpaste steuert und das Schrumpfverhalten der Leiterpaste und das der Glaskeramik einander entsprechen.

5. Verfahren zum Herstellen eines Keramikbauteils nach Anspruch 1, wobei die Leiterpaste, die in dem Leiterdruckschritt verwendet wird, Silberpulver und ein Molybdänoxid enthält und ein durchschnittlicher Teilchendurchmesser des Silberpulvers von 3 bis 8 µm reicht.

6. Verfahren zum Herstellen eines Keramikbauteils nach Anspruch 1, wobei der Brennschritt einen Temperaturerhöhungs-Teilschritt und einen Hochtemperatur-Aufrechterhaltungs-Teilschritt einschließt und eine Rate der Temperaturerhöhung in dem Temperaturerhöhungs-Teilschritt von 200 bis 5500°C/h reicht.

7. Verfahren zum Herstellen eines Keramikbauteils nach einem der Ansprüche 1 bis 6, wobei die Glaskeramik-Rohfolie, die Aluminiumoxid, Magnesiumoxid, ein Oxid eines spezifischen Lanthanoids und Glas enthält, verwendet wird.

8. Laminiertes Glaskeramik-Bauteil mit einer vorgegebenen Struktur der Leiterschicht, wobei die Glaskeramik Aluminiumoxid, Magnesiumoxid, ein Oxid eines spezifischen Lanthanoids und Glas enthält und der Leiter Silber als seinen Hauptbestandteil aufweist und ein Molybdänoxid in einer Menge von 0,1 bis 5 Gew.-% des gesamten Pulvers des Leiters enthält.

## Revendications

1. Procédé de fabrication d'un composant céramique incluant :
une étape d'impression d'un conducteur consistant à appliquer, à une feuille verte en vitrocéramique, une pâte d'un conducteur ayant substantiellement une même vitesse de frittage que la feuille verte en vitrocéramique ;
une étape de stratification consistant à stratifier une pluralité de feuilles vertes en vitrocéramique pour former un stratifié ;
une étape de stratification composite consistant à stratifier en plus, sur au moins un côté du stratifié, une feuille verte d'inhibition de thermorétrécissement basée sur un matériau inorganique pour former un stratifié composite ;
une étape de dissociation consistant à brûler un matériau organique depuis le stratifié composite ;
une étape de cuisson consistant à fritter le stratifié composite après l'enlèvement du matériau organique de sorte que les comportements de frittage des feuilles vertes en vitrocéramique et de la pâte d'un conducteur coïncident les uns avec les autres ; et
une étape consistant à enlever le matériau inorganique dans la feuille verte d'inhibition de thermorétrécissement.

2. Procédé de fabrication d'un composant céramique de la revendication 1, dans lequel, dans ladite étape de cuisson, le stratifié composite est fritté tandis qu'un oxyde de molybdène mélangé dans la pâte d'un conducteur régule une vitesse de frittage de la pâte d'un conducteur de sorte que la vitesse de frittage correspondante coïncide avec une vitesse de frittage de la vitrocéramique.

3. Procédé de fabrication d'un composant céramique de la revendication 1, dans lequel la pâte d'un conducteur utilisée dans ladite étape d'impression d'un conducteur inclut de la poudre d'argent et un oxyde de molybdène et un rapport de composition de l'oxyde de molybdène est 0,1 à 5 % en poids (sur une base de trioxyde de molybdène) de poudre entière du conducteur.

4. Procédé de fabrication d'un composant céramique de la revendication 1, dans lequel, dans ladite étape de cuisson, de la poudre d'argent ayant un diamètre de particule moyen dans la gamme de 3 à 8 µm est sélectionnée comme une poudre d'argent utilisée pour la pâte d'un conducteur, et ainsi le stratifié composite est fritté de sorte que la poudre d'argent régule une température de début de rétrécissement de la pâte d'un conducteur et que des comportements de rétrécissement de la pâte d'un conducteur et de la vitrocéramique coïncident les uns avec les autres.

5. Procédé de fabrication d'un composant céramique de la revendication 1, dans lequel la pâte d'un conducteur utilisée dans ladite étape d'impression d'un conducteur inclut de la poudre d'argent et un oxyde de molybdène, et un diamètre de particule moyen de la poudre d'argent est dans la gamme de 3 à 8 µm.

6. Procédé de fabrication d'un composant céramique de la revendication 1, dans lequel ladite étape de cuisson inclut une sous-étape d'élévation de température et une sous-étape de maintient de température élevée, et un taux d'élévation de température dans la sous-étape d'élévation de température est dans la gamme de 200 à 5500°C/hr.

7. Procédé de fabrication d'un composant céramique de l'une quelconque des revendications 1 à 6, dans lequel la feuille verte en vitrocéramique incluant de l'oxyde d'aluminium, de l'oxyde de magnésium, un oxyde d'un lanthanide spécifique et du verre est utilisée.

8. Composant en vitrocéramique stratifié ayant un modèle prédéterminé de couche d'un conducteur, dans lequel la vitrocéramique inclut de l'oxyde d'aluminium, de l'oxyde de magnésium, un oxyde de lanthanide spécifique, et du verre, et le conducteur a de l'argent comme constituant majeur correspondant et inclut un oxyde de molybdène dans une quantité de 0,1 à 5 % en poids de poudre entière du conducteur.
